# EUROPÄISCHE PATENTSCHRIFT

(11) **EP 3 834 277 B1**
(45) Veröffentlichungstag und Bekanntmachung des Hinweises auf die Patenterteilung: **29.06.2022**
(21) Anmeldenummer: 19821005.6
(22) Anmeldetag: 25.11.2019
(51) Int. Cl.: H02M 3/158, H01F 17/06, G01R 1/20, H02M 1/00

(54) **MESSSHUNT**
MEASURING SHUNT
SHUNT DE MESURE

(30) Priorität: 07.12.2018 EP 18211063
(43) Veröffentlichungstag der Anmeldung: 16.06.2021
(73) Patentinhaber: Siemens Aktiengesellschaft, 80333 München (DE)
(72) Erfinder: LORZ, Roland, 91341 Röttenbach (DE)
(86) Internationale Anmeldenummer: PCT/EP2019/082391
(87) Internationale Veröffentlichungsnummer: WO 2020/114818

(56) Entgegenhaltungen:
- DE-A1-102006 039 722
- US-A1- 2008 074 225
- US-A1- 2014 292 458
- US-A1- 2015 303 808
- ZIEGLER S ET AL: "Current Sensing Techniques: A Review", IEEE SENSORS JOURNAL, IEEE SERVICE CENTER, NEW YORK, NY, US, Bd. 9, Nr. 4, 1. April 2009 (2009-04-01), Seiten 354-376, XP011252969, ISSN: 1530-437X

## Beschreibung

Die Erfindung betrifft einen Messshunt, insbesondere für Schaltungsanordnungen mit parallel geschalteten Halbbrücken elektronischer Schalter und Stromrichter mit derartigen Schaltungsanordnungen.

Parallelschaltungen von Halbbrücken elektronischer Schalter werden insbesondere in Stromrichtern verwendet, um eine ausreichende Stromrichterleistung zu erzielen. Bei derartigen Parallelschaltungen werden elektronische Schalter räumlich nahe benachbart angeordnet, wodurch die elektronischen Schalter gekoppelt werden. Zur Entkoppelung der elektronischen Schalter können Induktivitäten verwendet werden, auf die aus Kostengründen jedoch häufig verzichtet wird. Messshunts werden in Stromrichtern unter anderem zur Messung von Phasenströmen eingesetzt, beispielsweise für eine Drehzahlregelung von Motoren, die über Stromrichter angetrieben werden.

US 2008/074225 A1 offenbart einen Induktor mit einem Induktorkörper. Durch den Induktorkörper verläuft ein Hohlraum zwischen zwei sich gegenüberliegenden Endoberflächen des Induktorkörpers. Durch den Hohlraum verläuft ein thermisch stabiles Widerstandselement, das einer oberen Oberfläche des Induktorkörpers zugewandt ist und oberflächenmontierbare Anschlüsse aufweist.

US 2014/292458 A1 offenbart eine magnetische Vorrichtung mit einem Magnetkern und einer leitenden Wicklung, die induktiv mit dem Magnetkern gekoppelt ist. Die leitende Wicklung enthält ein erstes Anschlusssegment, ein zweites Anschlusssegment und ein induktives Segment, das elektrisch in Reihe zwischen die Anschlusssegmente geschaltet ist. Das erste Anschlusssegment umfasst ein Stromerfassungselement.

Der Erfindung liegt die Aufgabe zugrunde, einen Messshunt anzugeben, der insbesondere für Schaltungsanordnungen mit parallel geschalteten Halbbrücken elektronischer Schalter und Stromrichter mit derartigen Schaltungsanordnungen verbessert ist.

Die Aufgabe wird erfindungsgemäß durch einen Messshunt mit den Merkmalen des Anspruchs 1, eine Schaltungsanordnung mit den Merkmalen des Anspruchs 6 und einen Stromrichter mit den Merkmalen des Anspruchs 7 gelöst.

Vorteilhafte Ausgestaltungen der Erfindung sind Gegenstand der Unteransprüche.

Ein erfindungsgemäßer Messshunt umfasst ein Widerstandselement mit zwei Hauptkontakten und einem zwischen den Hauptkontakten verlaufenden Mittelabschnitt zur Leitung eines elektrischen Stroms zwischen den beiden Hauptkontakten durch den Mittelabschnitt. Ferner weist der Messshunt einen magnetischen Kern auf, der ringartig um den Mittelabschnitt des Widerstandselements verläuft.

Der um das Widerstandselement verlaufende magnetische Kern verleiht dem Messshunt eine Induktivität, die zur Entkoppelung elektronischer Schalter in parallelgeschalteten Halbbrücken verwendet werden kann. Ein erfindungsgemäßer Messshunt ermöglicht daher neben einer Strommessung auch die Entkopplung elektronischer Schalter in parallelgeschalteten Halbbrücken. Außerdem ermöglicht ein erfindungsgemäßer Messshunt durch die Filterwirkung seiner Induktivität eine Begrenzung von Unsymmetrien und Spannungssteilheiten an den Ausgängen parallelgeschalteter Halbbrücken. Dadurch wird die Funktionalität des Messshunt vorteilhaft erhöht.

Der Messshunt weist außerdem zwei Hilfskontakte zum Abgreifen einer Messspannung auf, die zwischen zwei auf verschiedenen Seiten des magnetischen Kerns liegenden Messstellen des Widerstandselements abfällt. Dieser Aspekt der Erfindung ermöglicht eine Verbesserung der Messgenauigkeit des Messshunt durch eine Vierleitermessung, bei der ein durch das Widerstandselement fließender Strom über ein Messspannung gemessen wird, die an den Hilfskontakten abgegriffen wird.

Einer der Hilfskontakte verläuft von einer der Messstellen durch den magnetischen Kern. Dies verhindert, dass die an den Hilfskontakten abgegriffene Messspannung eine Spannung enthält, die durch den magnetischen Kern induziert wird und das Messsignal verfälscht.

Der Mittelabschnitt des Widerstandselements ist U-förmig ausgebildet. Dadurch kann der Messshunt in einfacher Weise mit den Hauptkontakten auf einem ebenen Schaltungsträger angeordnet werden.

Eine Ausgestaltung der Erfindung sieht vor, dass der magnetische Kern aus zwei aneinandergefügten Kernteilen besteht. Diese Ausgestaltung der Erfindung ermöglicht eine einfache Montage des magnetischen Kerns um das Widerstandselement durch Zusammenfügen der beiden Kernteile.

Eine weitere Ausgestaltung der Erfindung sieht vor, dass der magnetische Kern von dem Widerstandselement durch einen Luftspalt beabstandet ist. Durch den Luftspalt kann vorteilhaft eine Induktivität des Messshunt beeinflusst werden.

Eine zu den beiden vorgenannten Ausgestaltungen alternative Ausgestaltung der Erfindung sieht vor, dass der magnetische Kern um den Mittelabschnitt des Widerstandselements spritzgegossen ist. Diese Ausgestaltung der Erfindung ermöglicht eine einfache serienmäßige Fertigung des Messshunt durch Spritzgießen des magnetischen Kerns.

Der magnetische Kern ist vorzugsweise aus einem Material mit einer hohen magnetischen Permeabilität, einer hohen Sättigungsmagnetisierung und/oder geringen frequenzabhängigen magnetischen Verlusten gefertigt. Beispielsweise ist der magnetische Kern aus Eisen oder einem ferrimagnetischen Material gefertigt. Wenn der magnetische Kern spritzgegossen wird, wird er beispielsweise aus einem Gemisch eines Trägermaterials, beispielsweise eines Kunststoffs, und eines magnetischen Materials, beispielsweise eines magnetischen Pulvers wie Eisenpulver oder eines ferrimagnetischen Pulvers, gefertigt.

Das Widerstandselement ist vorzugsweise aus einem Material gefertigt, das einen geringen spezifischen elektrischen Widerstand und eine geringe Temperaturabhängigkeit seines elektrischen Widerstands aufweist. Beispielsweise ist das Widerstandselement aus einer Kupfer-Nickel-Mangan-Legierung gefertigt.

Eine erfindungsgemäße Schaltungsanordnung weist wenigstens zwei zueinander parallel geschaltete Halbbrücken auf, in deren Brückenarmen jeweils wenigstens ein elektronischer Schalter angeordnet ist, wobei in dem Brückenzweig jeder Halbbrücke ein erfindungsgemäßer Messshunt angeordnet ist. Durch die Messshunts können einerseits die in den Brückenzweigen fließenden Ströme gemessen werden und andererseits werden die parallel geschalteten Halbbrücken entkoppelt, ohne weitere Bauelemente verwenden zu müssen. Außerdem wird durch die Filterwirkung des Messshunt eine Spannungssteilheit an dem Ausgang der Schaltungsanordnung begrenzt.

Ein erfindungsgemäßer Stromrichter weist wenigstens eine erfindungsgemäße Schaltungsanordnung parallel geschalteter Halbbrücken mit elektronischen Schaltern auf. Die Vorteile eines derartigen Stromrichters ergeben sich aus den oben genannten Vorteilen einer erfindungsgemäßen Schaltungsanordnung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
- FIG 1: eine erste perspektivische Darstellung eines Messshunt,
- FIG 2: eine zweite perspektivische Darstellung des in FIG 1 gezeigten Messshunt,
- Fig 3: eine Schaltungsanordnung mit zwei zueinander parallel geschalteten Halbbrücken elektronischer Schalter,
- FIG 4: einen Schaltplan eines Stromrichters.

Einander entsprechende Teile sind in den Figuren mit denselben Bezugszeichen versehen.

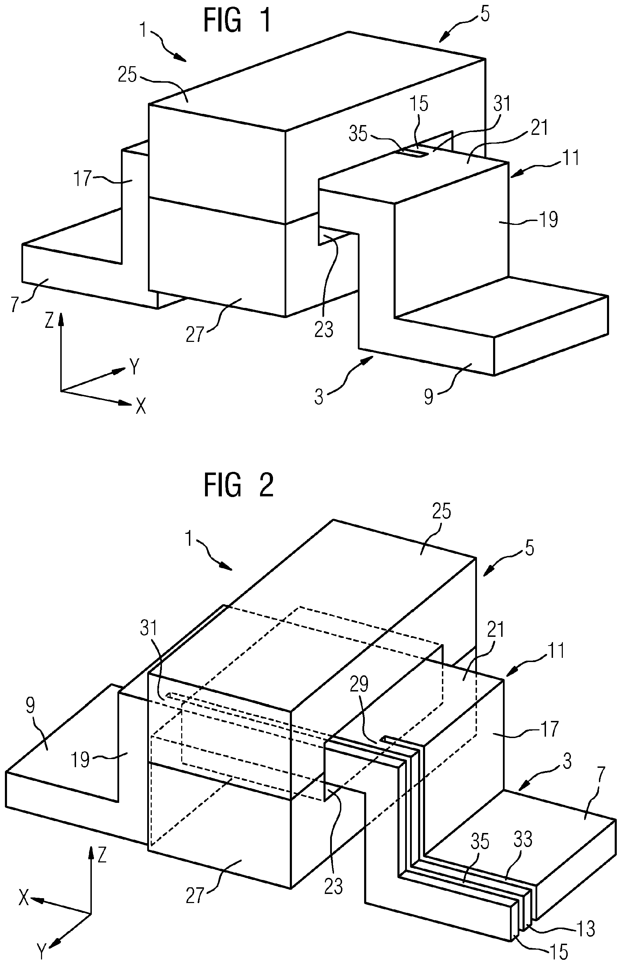

Die Figuren 1 und 2 zeigen zwei verschiedene perspektivische Darstellungen eines Ausführungsbeispiels eines erfindungsgemäßen Messshunt 1, wobei zur Verdeutlichung der dargestellten Perspektiven jeweils ein kartesisches Koordinatensystem mit Koordinaten X, Y, Z gezeichnet ist. Der Messshunt 1 weist ein Widerstandselement 3 und einen magnetischen Kern 5 auf.

Das Widerstandselement 3 weist zwei Hauptkontakte 7, 9, einen Mittelabschnitt 11 und zwei Hilfskontakte 13, 15 auf. Der Mittelabschnitt 11 verläuft zwischen den Hauptkontakten 7, 9. Der Mittelabschnitt 11 ist U-förmig mit zwei Schenkeln 17, 19 und einem zwischen den Schenkeln 17, 19 verlaufenden Zentralabschnitt 21 ausgebildet. Jeder Hauptkontakt 7, 9 ist von einem der Schenkel 17, 19 abgewinkelt, so dass die Hauptkontakte 7, 9 an einander gegenüberliegenden Seiten und voneinander weggerichtet von dem Mittelabschnitt 11 abstehen.

Der magnetische Kern 5 verläuft ringartig um den Zentralabschnitt 21 des Widerstandselements 3 und ist von dem Zentralabschnitt 21 durch einen Luftspalt 23 beabstandet. Der magnetische Kern 5 besteht aus zwei aneinandergefügten Kernteilen 25, 27, die jeweils U-förmig ausgebildet sind. Der magnetische Kern 5 hat die Form eines Quaders mit einer Öffnung, durch die der Zentralabschnitt 21 des Widerstandselements 3 verläuft.

Jeder Hilfskontakt 13, 15 verläuft von einer Messstelle 29, 31 in dem Zentralabschnitt 21 zu einem Ende des Widerstandselements 3 in dem Bereich eines ersten Hauptkontaktes 7. Dabei sind die beiden Messstellen 29, 31 auf voneinander verschiedenen Seiten des magnetischen Kerns 5 angeordnet. Ein erster Hilfskontakt 13 verläuft von einer ersten Messstelle 29 vollständig auf einer dem ersten Hauptkontakt 7 zugewandten Seite des magnetischen Kerns 5. Der zweite Hilfskontakt 15 verläuft von der zweiten Messstelle 31, die auf einer dem zweiten Hauptkontakt 9 zugewandten Seite des magnetischen Kerns 5 liegt, durch den magnetischen Kern 5 zu der dem ersten Hauptkontakt 7 zugewandten Seite des magnetischen Kerns 5.

Die Hilfskontakte 13, 15 des in den Figuren 1 und 2 gezeigten Ausführungsbeispiels eines Messshunt 1 werden durch zwei Schlitze 33, 35 in dem Widerstandselement 3 erzeugt, die jeweils durch einen Teilbereich des Zentralabschnitts 21 und einen ersten Schenkel 17 des Mittelabschnitts 11 zu dem Ende des Widerstandselements 3 in dem Bereich des ersten Hauptkontaktes 7 verlaufen. Die Schlitze 33, 35 trennen die beiden Hilfskontakte 13, 15 voneinander und von dem ersten Hauptkontakt 7, wobei ein erster Schlitz 33 den ersten Hilfskontakt 13 von dem ersten Hauptkontakt 7 trennt und der zweite Schlitz 35 die beiden Hilfskontakte 13, 15 voneinander trennt.

Das Widerstandselement 3 dient der Messung eines elektrischen Stroms, der zwischen den Hauptkontakten 7, 9 durch den Mittelabschnitt 3 fließt. Der elektrische Strom wird nach dem Prinzip einer Vierleitermessung über eine zwischen den beiden Messstellen 29, 31 anliegende elektrische Messspannung gemessen, die an den Hilfskontakten 13, 15 abgegriffen wird.

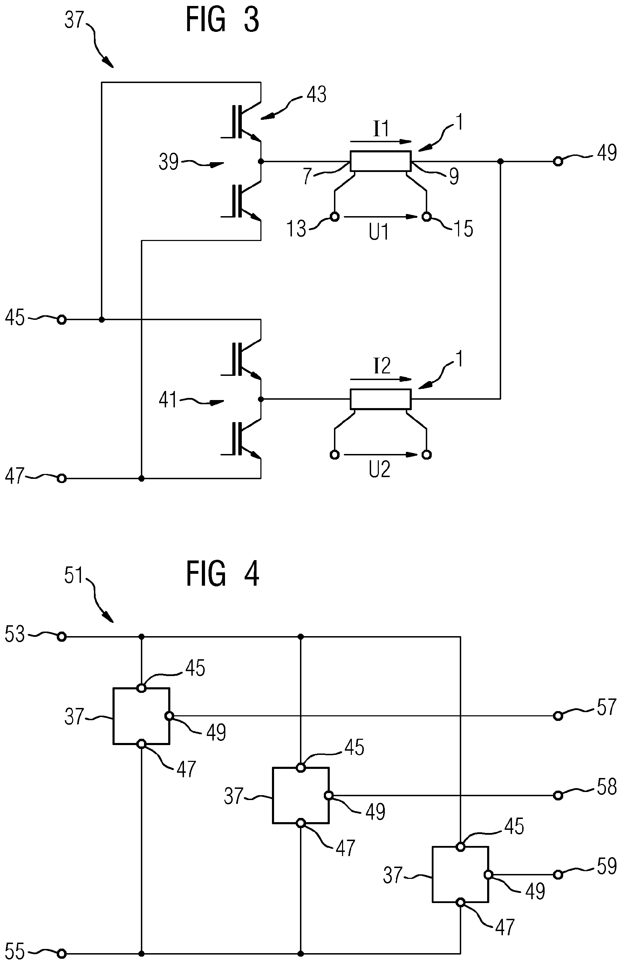

Der magnetische Kern 5 dient der Entkoppelung parallel geschalteter elektronischer Schalter 43 wie bei der in FIG 3 gezeigten Schaltungsanordnung 37.

In alternativen Ausführungsbeispielen des Messshunt 1 können die Hilfskontakte 13, 15 in anderer Weise als in dem in den Figuren 1 und 2 gezeigten Ausführungsbeispiel ausgeführt sein. Wesentlich ist dabei jedoch, dass einer der beiden Hilfskontakte 13 oder 15 parallel zu einer Fließrichtung eines durch das Widerstandselement 3 fließenden elektrischen Stroms durch den magnetischen Kern 5 verläuft. Ferner kann der magnetische Kern 5 in anderer Weise ausgeführt sein als in dem in den Figuren 1 und 2 gezeigten Ausführungsbeispiel. Beispielsweise kann der magnetische Kern 5 um den Mittelabschnitt 11 des Widerstandselements 3 spritzgegossen werden, beispielsweise aus einem Gemisch eines Trägermaterials, beispielsweise eines Kunststoffs, und eines magnetischen Materials, beispielsweise eines magnetischen Pulvers.

FIG 3 zeigt einen Schaltplan eines Ausführungsbeispiels einer erfindungsgemäßen Schaltungsanordnung 37 mit zwei zueinander parallel geschalteten Halbbrücken 39, 41, in deren Brückenarmen jeweils ein elektronischer Schalter 43 angeordnet ist. In dem Brückenzweig jeder Halbbrücke 39, 41 ist ein wie in den Figuren 1 und 2 ausgebildeter Messshunt 1 angeordnet, mit dem ein in dem Brückenzweig und durch das Widerstandselement 3 des Messshunt 1 fließender elektrischer Strom I1, I2 über eine elektrische Messspannung U1, U2 gemessen wird, die an den Hilfskontakten 13, 15 des Messshunt 1 abgegriffen wird. Ein erster Brückenarm jeder Halbbrücke 39, 41 ist mit einem ersten Gleichspannungsanschluss 45 der Schaltungsanordnung 37 verbunden. Der zweite Brückenarm jeder Halbbrücke 39, 41 ist mit einem zweiten Gleichspannungsanschluss 47 der Schaltungsanordnung 37 verbunden. Die Messhunts 1 sind ausgangsseitig mit einem Wechselspannungsanschluss 49 der Schaltungsanordnung 37 verbunden. Die elektronischen Schalter 43 sind in dem in FIG 3 gezeigten Ausführungsbeispiel einer erfindungsgemäßen Schaltungsanordnung 37 Bipolartransistoren mit isolierter Gate-Elektrode (IGBT), können in anderen Ausführungsbeispielen jedoch auch andere Halbleiterschalter sein, beispielsweise Metall-Oxid-Halbleiter-Feldeffekttransistoren (MOSFET). FIG 4 zeigt einen Schaltplan eines Ausführungsbeispiels eines erfindungsgemäßen Stromrichters 51. Der Stromrichter 51 weist zwei Stromrichtergleichspannungsanschlüsse 53, 55, drei Stromrichterwechselspannungsanschlüsse 57 bis 59 und drei jeweils wie in FIG 3 ausgebildete Schaltungsanordnungen 37 auf. Der erste Gleichspannungsanschluss 45 jeder Schaltungsanordnung 37 ist mit einem ersten Stromrichtergleichspannungsanschluss 53 verbunden. Der zweite Gleichspannungsanschluss 47 jeder Schaltungsanordnung 37 ist mit dem zweiten Stromrichtergleichspannungsanschluss 55 verbunden. Der Wechselspannungsanschluss 49 jeder Schaltungsanordnung 37 ist mit einem Stromrichterwechselspannungsanschluss 57 bis 59 verbunden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen, der in den beigefügten Ansprüchen definiert ist.

## Patentansprüche

1. Messshunt (1), umfassend
- ein Widerstandselement (3) mit einem ersten Hauptkontakt (7), einem zweiten Hauptkontakt (9) und einem zwischen den Hauptkontakten (7,9) verlaufenden Mittelabschnitt (11) zur Leitung eines elektrischen Stroms (I1,I2) zwischen den beiden Hauptkontakten (7,9) durch den Mittelabschnitt (11),
- einen magnetischen Kern (5), der ringartig um den Mittelabschnitt (11) des Widerstandselements (3) verläuft und
- einen ersten Hilfskontakt (13) und einen zweiten Hilfskontakt (15) zum Abgreifen einer Messspannung (U1,U2), die zwischen einer ersten Messstelle (29) und einer zweiten Messstelle (31) des Widerstandselements (3) abfällt, wobei
- die Messstellen (29,31) auf verschiedenen Seiten des magnetischen Kerns (5) liegen,
- der Mittelabschnitt (11) U-förmig mit zwei Schenkeln (17,19) und einem zwischen den Schenkeln (17,19) verlaufenden Zentralabschnitt (21) ausgebildet ist,
- der zweite Hilfskontakt (15) von der zweiten Messstelle (31), die auf einer dem zweiten Hauptkontakt (9) zugewandten Seite des magnetischen Kerns (5) liegt, durch den magnetischen Kern (5) zu der dem ersten Hauptkontakt (7) zugewandten Seite des magnetischen Kerns (5) verläuft, und
- die Hilfskontakte (13,15) durch zwei Schlitze (33,35) in dem Widerstandselement (3) erzeugt werden, die jeweils durch einen Teilbereich des Zentralabschnitts (21) und einen ersten Schenkel (17) des Mittelabschnitts (11) zu dem Ende des Widerstandselements (3) in dem Bereich des ersten Hauptkontaktes (7) verlaufen.

2. Messshunt (1) nach Anspruch 1, wobei der erste Hilfskontakt (13) von der ersten Messstelle (29) vollständig auf einer dem ersten Hauptkontakt (7) zugewandten Seite des magnetischen Kerns (5) verläuft.

3. Messshunt (1) nach einem der vorhergehenden Ansprüche, wobei der magnetische Kern (5) aus zwei aneinandergefügten Kernteilen (25,27) besteht.

4. Messshunt (1) nach einem der vorhergehenden Ansprüche, wobei der magnetische Kern (5) von dem Widerstandselement (3) durch einen Luftspalt (23) beabstandet ist.

5. Messshunt (1) nach Anspruch 1 oder 2, wobei der magnetische Kern (5) um den Mittelabschnitt (11) des Widerstandselements (3) spritzgegossen ist.

6. Schaltungsanordnung (37) mit wenigstens zwei zueinander parallel geschalteten Halbbrücken (39,41), in deren Brückenarmen jeweils wenigstens ein elektronischer Schalter (43) angeordnet ist, wobei in dem Brückenzweig jeder Halbbrücke (39, 41) ein Messshunt (1) gemäß einem der vorhergehenden Ansprüche angeordnet ist.

7. Stromrichter (51) mit wenigstens einer Schaltungsanordnung (37) gemäß Anspruch 6.

## Claims

1. Measuring shunt (1), comprising
- a resistance element (3) having a first main contact (7), a second main contact (9) and a middle section (11) extending between the main contacts (7, 9) for conducting an electric current (11,12) between the two main contacts (7,9) through the middle section (11),
- a magnetic core (5) which extends in an annular manner around the middle section (11) of the resistance element (3) and
- a first auxiliary contact (13) and a second auxiliary contact (15) for tapping a measurement voltage (U1, U2) which drops between a first measurement point (29) and a second measurement point (31) of the resistance element (3), wherein
- the measurement points (29, 31) are located on different sides of the magnetic core (5),
- the middle section (11) is embodied as U-shaped with two limbs (17, 19) and a central section (21) extending between the limbs (17, 19),
- the second auxiliary contact (15) extends from the second measurement point (31) located on a side of the magnetic core (5) facing the second main contact (9), through the magnetic core (5) to the side of the magnetic core (5) facing the first main contact (7), and
- the auxiliary contacts (13,15) are generated by two slots (33, 35) in the resistance element (3) which each extend through a subsection of the central section (21) and a first limb (17) of the middle section (11) to the end of the resistance element (3) in the region of the first main contact (7).

2. Measuring shunt (1) according to claim 1, wherein the first auxiliary contact (13) extends from the first measurement point (29) entirely on one side of the magnetic core (5) facing the first main contact (7).

3. Measuring shunt (1) according to one of the preceding claims, wherein the magnetic core (5) consists of two core parts (25, 27) joined together.

4. Measuring shunt (1) according to one of the preceding claims, wherein the magnetic core (5) is spaced apart from the resistance element (3) by an air gap (23).

5. Measuring shunt (1) according to claim 1 or 2, wherein the magnetic core (5) is injection-moulded around the middle section (11) of the resistance element (3).

6. Circuit arrangement (37) having at least two half-bridges (39, 41) connected in parallel, in each of the bridge arms of which at least one electronic switch (43) is arranged, wherein a measuring shunt (1) according to one of the preceding claims is arranged in the bridge arm of each half-bridge (39, 41).

7. Power converter (51) having at least one circuit arrangement (37) according to claim 6.

## Revendications

1. Shunt (1) de mesure, comprenant
- un élément (3) résistant ayant un premier contact (7) principal et un deuxième contact (9) principal et une partie (11) médiane, s'étendant entre les contacts (7, 9) principaux, pour le passage d'un courant (I1, I2) électrique entre les deux contacts (7, 9) principaux par la partie (11) médiane,
- un noyau (5) magnétique, qui s'étend à la manière d'un anneau autour de la partie (11) médiane de l'élément (3) résistant et
- un premier contact (13) auxiliaire et un deuxième contact (15) auxiliaire pour le prélèvement d'une tension (U1, U2) de mesure, qui chute entre un premier point (29) de mesure et un deuxième point (31) de mesure de l'élément (3) résistant, dans lequel
- les points (29, 31) de mesure sont sur des côtés différents du noyau (5) magnétique,
- la partie (11) médiane est constituée en forme de U en ayant deux branches (17, 19) et une partie (21) centrale s'étendant entre les branches (17, 19),
- le deuxième contact (15) auxiliaire s'étend du deuxième point (31) de mesure, qui est du côté du noyau (5) magnétique, tourné vers le deuxième contact (9) principal, au côté du noyau (5) magnétique, tourné vers le premier contact (7) principal, en passant à travers le noyau (5) magnétique, et
- les contacts (13, 15) auxiliaires sont produits par deux fentes (33, 35) dans l'élément (3) résistant, qui s'étendent respectivement, en passant par une région partielle de la partie (21) centrale et une première branche (17) de la partie (11) centrale, vers l'extrémité de l'élément (3) résistant, dans la région du premier contact (7) principal.

2. Shunt (1) de mesure suivant la revendication 1, dans lequel le premier contact (13) auxiliaire s'étend du premier point (29) de mesure complètement d'un premier côté d'un noyau (5) magnétique, tourné vers le premier contact (7) principal.

3. Shunt (1) suivant l'une des revendications précédentes, dans lequel le noyau (5) magnétique est constitué de deux parties (25, 27) de noyau assemblées l'une à l'autre.

4. Shunt (1) suivant l'une des revendications précédentes, dans lequel le noyau (5) magnétique est à distance de l'élément (3) résistant par un entrefer (23).

5. Shunt (1) suivant la revendication 1 ou 2, dans lequel le noyau (5) magnétique est coulé par injection autour de la partie (11) médiane de l'élément (3) résistant.

6. Montage (37) ayant au moins deux demi-ponts (39, 41) montés en parallèle l'un avec l'autre, respectivement au moins un interrupteur (43) électronique dans leurs bras de pont, dans lequel un shunt (1) de mesure suivant l'une des revendications précédentes est monté dans la branche de pont de chaque demi-pont (39, 41).

7. Convertisseur (51) ayant au moins un montage (37) suivant la revendication 6.
